# EUROPÄISCHE PATENTANMELDUNG

(11) **EP 0 781 080 A1**
(43) Veröffentlichungstag der Anmeldung: **25.06.1997**
(21) Anmeldenummer: 96120162.1
(22) Anmeldetag: 16.12.1996
(51) Int. Cl.: H05K 5/00

(54) **Gehäuse zur Aufnahme von elektronischen Bauelementen**

(30) Priorität: 23.12.1995 DE 19548723
(71) Anmelder: ROBERT BOSCH GMBH, 70442 Stuttgart (DE)
(72) Erfinder: Scholtz, Klaus, 12277 Berlin (DE); Steiger, Klaus-Henning, 14052 Berlin (DE); Siebeneicher, Wolfgang, 12203 Berlin (DE); Meissner, Guenter, 12249 Berlin (DE)

(57) **Zusammenfassung**

Es wird ein Gehäuse vorgeschlagen, das hermetisch abgeschlossen und elektromagnetisch abgeschirmt ist und zur Aufnahme von elektronischen Bauelementen dient. Das Gehäuse umfaßt ein erstes Gehäuseteil (1), das wannenförmig ausgebildet ist und einen vorzugsweise auskragenden umlaufenden Rand (5) aufweist und ein zweites als Gehäusedeckel (10) ausgebildetes Gehäuseteil, das auf dem umlaufenden Rand (5) des ersten Gehäuseteils (1) aufliegt, diesen umschließt und mit seinem Rand (15) gegen die Außenwand (20) des ersten Gehäuseteils (1) drückt. Der Gehäusedeckel (10) kann auch an der Innenwand (25) des ersten Gehäuseteils (1) anliegen und gegen die Innenwand (25) drücken.

## Beschreibung

### Stand der Technik

Die Erfindung geht von einem Gehäuse zur Aufnahme von elektronischen Bauelementen nach der Gattung des Hauptanspruchs aus.

Aus der EP 0 499 607 B 1 ist ein Gehäuse für eine elektronische Schaltung bekannt, mit 2 wannenförmigen, metallischen Druckgußteilen, die am Wannenrand ausgebildete, umlaufende Flanschkragen aufweisen, die mit Gewindebohrungen bzw. Durchgangslöchern für Gewindeschrauben versehen sind, mit denen die beiden Gehäuseteile verspannt werden können. Die beiden Gehäuseteile weisen an ihren Flanschkragen jeweils eine umlaufende Nut auf, die zur Aufnahme einer Dichtung vorgesehen ist. Zwischen den beiden Gehäuseteilen ist eine Bodenwand angeordnet. Die beiden Gehäuseteile stehen über ein an einem Seitenrand des Gehäuses angeordnetes Scharnier schwenkbeweglich miteinander in Verbindung.

### Vorteile der Erfindung

Das erfindungsgemäße Gehäuse mit den Merkmalen des Hauptanspruchs hat demgegenüber den Vorteil, daß die beiden Gehäuseteile ohne den Einsatz von Flanschkragen und ohne die Verwendung von Gewindebohrungen und Gewindeschrauben auf einfache und wenig aufwendige Weise miteinander verbunden sind. Eine aufwendige schwenkbewegliche Verbindung durch ein Scharnier ist ebenfalls nicht vorgesehen.

Als weiterer Vorteil ist anzusehen, daß das zweite Gehäuseteil auf dem umlaufenden Rand des ersten Gehäuseteils aufliegt, diesen umschließt und mit seinem Rand gegen die Außenwand des ersten Gehäuseteils drückt. Auf diese Weise ist das Gehäuse hermetisch abgeschlossen, so daß keine zusätzliche Dichtung benötigt wird.

Vorteilhaft ist auch, daß das Gehäuse nur 2 Teile erfordert, die nicht noch von einer Bodenwand voneinander getrennt werden müssen.

Durch die in den Unteransprüchen aufgeführten Maßnahmen sind vorteilhafte Weiterbildungen und Verbesserungen des im Hauptanspruch angegebenen Gehäuses möglich.

Vorteilhaft gemäß Anspruch 2 ist das Drücken des Gehäusedeckels gegen die Innenwand des ersten Gehäuseteils. Dadurch wird der Innenraum des Gehäuses noch besser abgedichtet und vor Umwelteinflüssen geschützt.

Vorteilhaft nach Anspruch 3 und Anspruch 4 ist die Lasche zum Öffnen des Gehäuses und der geprägte Streifen zur Aufnahme eines Hilfswerkzeuges. Auf diese Weise läßt sich das Gehäuse auf einfache und schnelle Weise öffnen, ohne daß das Lösen von Gewindeschrauben erforderlich ist.

Besonders vorteilhaft nach Anspruch 6 ist die Verwendung von metallischem Material geringer Wandstärke, vorzugsweise von Weißblech, Aluminium oder dergleichen. Dadurch sind kleinstmögliche Geräteabmessungen bei geringem Gewicht möglich. Außerdem ergeben sich bei der Herstellung weniger Aufwand und weniger Kosten als dies bei der Verwendung von Druckgußteilen der Fall ist. Besonders vorteilhaft ist auch die vergleichsweise einfache Zuführbarkeit des verwendeten Materials in den Recyclingkreislauf, da kein Lack, Pulver oder dergleichen anfällt.

### Zeichnung

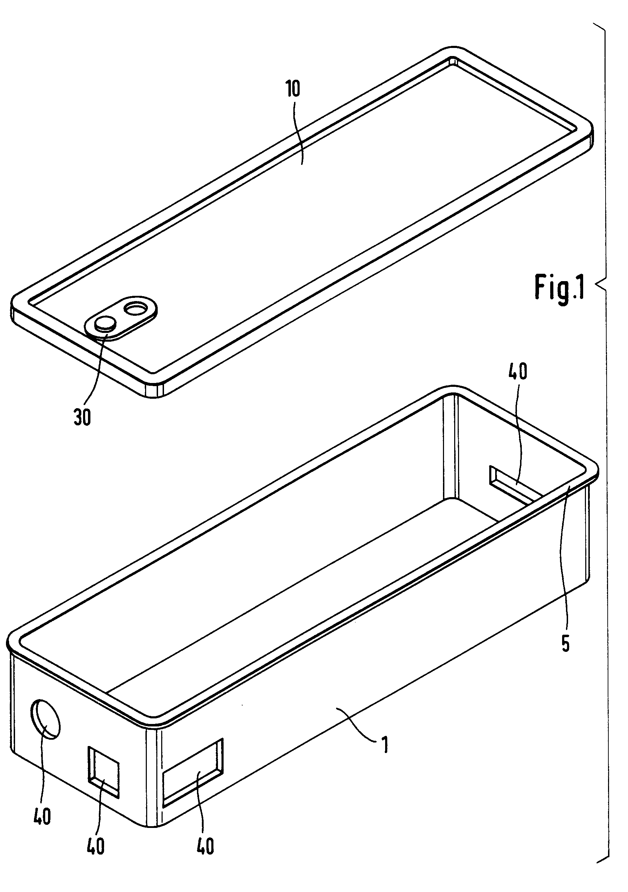

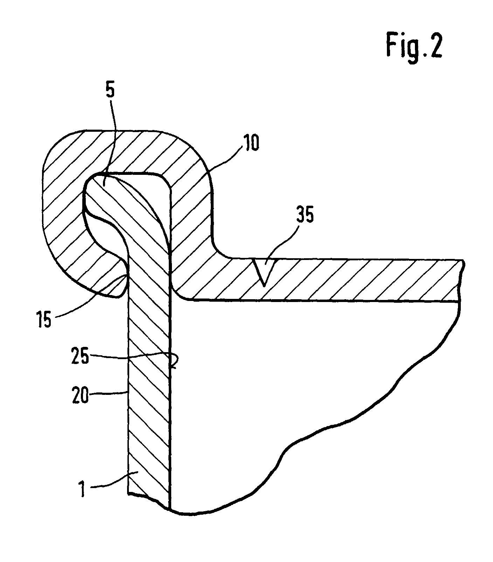

Ein Ausführungsbeispiel der Erfindung ist in der Zeichnung dargestellt und in der nachfolgenden Beschreibung näher erläutert. Es zeigen Figur 1 ein erstes Gehäuseteil und einen zugehörigen Gehäusedeckel als Einzelteile und Figur 2 exemplarisch die Verbindung der beiden Gehäuseteile.

### Beschreibung des Ausführungsbeispiels

In Figur 1 kennzeichnet 1 ein erstes Gehäuseteil, das wannenförmig ausgebildet ist und einen auskragenden, umlaufenden Rand 5 aufweist. Das erste Gehäuseteil 1 weist einen kreisrunden und 3 rechteckige Durchbrüche 40 auf, die zum Einbau von Bedienelementen, Anschlußelementen oder dergleichen vorgesehen sind. Ein zweites als Gehäusedeckel 10 ausgebildetes Gehäuseteil weist eine Lasche 30 zum Öffnen des Gehäuses auf und ist ebenfalls in Figur 1 dargestellt.

In Figur 2 ist die Verbindung der beiden Gehäuseteile 1 und 10 dargestellt. Der Gehäusedeckel 10 liegt an einer Innenwand 25 des ersten Gehäuseteils 1 an und drückt gegen diese Innenwand 25. Im Bereich dieser Verbindung ist der Gehäusedeckel 10 rechtwinklig abgebogen und bildet eine Schlaufe, die den umlaufenden Rand 5 des ersten Gehäuseteils 1 umschließt. Auf diese Weise liegt der Gehäusedeckel 10 auf dem umlaufenden Rand 5 auf. Mit seinem Rand 15 drückt der Gehäusedeckel 10 gegen eine Außenwand 20 des ersten Gehäuseteils 1. Auf der der Innenwand 25 zugewandten Seite des Gehäuses weist der Gehäusedeckel 10 in einem Abstand von der Innenwand 25 einen geprägten Streifen 35 zur Aufnahme eines Hilfswerkzeuges, vorzugsweise eines Büchsenöffners, auf.

Die beschriebene Verbindung der beiden Gehäuseteile 1 und 10 wird beispielsweise durch Bördelung erreicht. Durch die Druckverbindungen an der Außenwand 20 und der Innenwand 25 sowie der Auflage des Gehäusedeckels 10 bzw. dessen Umschließen des umlaufenden Randes 5 des ersten Gehäuseteils 1 wird das Gehäuseinnere vor Umwelteinflüssen, wie Staub und Feuchtigkeit, geschützt. Das Gehäuse ist somit hermetisch abgeschlossen. Eine elektromagnetische Abschirmung des Gehäuses ergibt sich bei Verwendung von metallischem Material für die beiden Gehäuseteile. Vorzugsweise verwendet man dafür Weißblech, Aluminium oder dergleichen mit geringer Wandstärke, so daß kleinstmögliche Abmessungen bei geringem Gewicht möglich sind. Der geprägte Streifen 35 dient zur Aufnahme eines Hilfswerkzeuges, vorzugsweise eines Büchsenöffners. Damit läßt sich der Gehäusedeckel 10 an vorgegebenen Stellen aufschlitzen und partiell mit der Lasche 30 vom Gehäuse abziehen. Auf diese Weise läßt sich das Gehäuse öffnen. Das hermetisch abgeschlossene und elektromagnetisch abgeschirmte Gehäuse dient zur Aufnahme von vorzugsweise störstrahlungsempfindlichen elektronischen Bauelementen, die auch zu einer elektronischen Schaltung kombiniert sein können. Das Gehäuse kann mit Kunststoff verkleidet sein.

Bei anderen Ausführungsformen der Erfindung kann der Rand 5 des ersten Gehäuseteils 1 auch nichtauskragend ausgebildet sein. Auch ist es nicht unbedingt erforderlich, daß der Gehäusedeckel 10 gegen die Innenwand 25 drückt. Der Gehäusedeckel 10 muß also auch nicht unbedingt rechtwinklig gegen die Innenwand 25 geführt sein. Allerdings ist dann die Verbindung der beiden Gehäuseteile 1 und 10 und damit die Abdichtung nur noch über den umlaufenden Rand 5 des ersten Gehäuseteils 1 und den Rand 15 des Gehäusedeckels 10 gewährleistet.

## Patentansprüche

1. Gehäuse zur Aufnahme von elektronischen Bauelementen, das hermetisch abgeschlossen und elektromagnetisch abgeschirmt ist, dadurch gekennzeichnet, daß ein erstes Gehäuseteil (1) wannenförmig ausgebildet ist und einen vorzugsweise auskragenden umlaufenden Rand (5) aufweist und daß ein zweites als Gehäusedeckel (10) ausgebildetes Gehäuseteil vorgesehen ist, das auf dem umlaufenden Rand (5) des ersten Gehäuseteils (1) aufliegt, diesen umschließt und mit seinem Rand (15) gegen die Außenwand (20) des ersten Gehäuseteils (1) drückt.

2. Gehäuse nach Anspruch 1, dadurch gekennzeichnet, daß der Gehäusedeckel (10) an der Innenwand (25) des ersten Gehäuseteils (1) anliegt und gegen die Innenwand (25) drückt.

3. Gehäuse nach Anspruch 1 oder 2, dadurch gekennzeichnet, daß der Gehäusedeckel (10) eine Lasche (30) zum Öffnen des Gehäuses aufweist.

4. Gehäuse nach Anspruch 1, 2 oder 3, dadurch gekennzeichnet, daß der Gehäusedeckel (10) einen geprägten Streifen (35) zur Aufnahme eines Hilfswerkzeuges, vorzugsweise eines Büchsenöffners aufweist.

5. Gehäuse nach einem der vorherigen Ansprüche, dadurch gekennzeichnet, daß der erste Gehäuseteil (1) Durchbrüche (40) für Bedienelemente, Anschlußelemente oder dergleichen aufweist.

6. Gehäuse nach einem der vorherigen Ansprüche, dadurch gekennzeichnet, daß die beiden Gehäuseteile (1, 10) aus metallischem Material geringer Wandstarke, vorzugsweise aus Weißblech, Aluminium oder dergleichen gefertigt sind.

7. Gehäuse nach einem der vorherigen Ansprüche, dadurch gekennzeichnet, daß das Gehäuse eine Kunststoffverkleidung aufweist.
